Europäisches Patentamt

European Patent Office

Office européen des brevets

(11) Publication number: **0 086 010**
**B1**

## (12) EUROPEAN PATENT SPECIFICATION

(45) Date of publication of patent specification: **14.08.85**

(21) Application number: **83200124.2**

(22) Date of filing: **26.01.83**

(51) Int. Cl.⁴: **H 01 L 29/36,** H 01 L 29/06, H 01 L 21/76

(54) Semiconductor device having a reduced surface field strength.

(30) Priority: **08.02.82 NL 8200464**

(43) Date of publication of application:
**17.08.83 Bulletin 83/33**

(45) Publication of the grant of the patent:
**14.08.85 Bulletin 85/33**

(84) Designated Contracting States:
**DE FR GB IT NL**

(56) References cited:
**FR-A-2 325 196**
**FR-A-2 348 579**
**FR-A-2 393 423**

**INTERNATIONAL ELECTRON DEVICES MEETING, 8th-10th December 1980, Washington DC, pages 87-90, IEEE, New York, USA. H.M.J. VAES et al.: "High voltage, high current lateral devices".**

(73) Proprietor: **N.V. Philips' Gloeilampenfabrieken Groenewoudseweg 1 NL-5621 BA Eindhoven (NL)**

(72) Inventor: **Ludikhuize, Adrianus Willem c/o INT. OCTROOIBUREAU B.V. Prof. Holstlaan 6 NL-5656 AA Eindhoven (NL)**
Inventor: **Vaes, Henricus Maria Joseph c/o INT. OCTROOIBUREAU B.V. Prof. Holstlaan 6 NL-5656 AA Eindhoven (NL)**
Inventor: **Appels, Johannes Arnoldus c/o INT. OCTROOIBUREAU B.V. Prof. Holstlaan 6 NL-5656 AA Eindhoven (NL)**

(74) Representative: **Voorrips, Hugo Carel et al INTERNATIONAAL OCTROOIBUREAU B.V. Prof. Holstlaan 6 NL-5656 AA Eindhoven (NL)**

Courier Press, Leamington Spa, England.

## Description

The invention relates to a semiconductor device of the reduced surface field strength (RESURF) type having a semiconductor body comprising a substrate region of a first conductivity type and an adjoining semiconductor layer of the second, opposite conductivity type which adjoins a surface of the semiconductor body and forms with the substrate region a p-n junction which in the operating condition is reverse biased, within which semiconductor layer at least one zone of a semiconductor circuit element is provided, in which locally the semiconductor layer is depleted throughout its thickness and the substrate region is depleted over only a part of its thickness at a reverse voltage across the p-n junction which is lower than the breakdown voltage.

A semiconductor device of the kind described is known from the article by J. A. Appels et al., entitled "Thin-Layer High-Voltage devices (RESURF-Devices)" in Philips Journal of Research, vol. 35, No. 1, 1980, pp. 1—13.

It is to be noted that in the operating condition the reverse voltage may vary over the said p-n-junction, for example, as a result of a voltage drop by currents flowing parallel to the surface. As a result of such a voltage drop it may happen that, for example, the semiconductor layer, in places where the reverse voltage is comparatively high, is depleted over its entire thickness and, in places where the reverse voltage is comparatively low, is not depleted over its entire thickness. It is necessary that in the operating condition depletion can occur throughout the thickness of the semiconductor layer in those places where the surface field strength is high.

Semiconductor devices as described above have a reduced surface field strength and are known as "RESURF" devices ("RESURF"=REduced SURface Field). In such devices the breakdown voltage of the p-n junction may be very high and may nearly approach or may even equal the so-called unidimensionally computed value (in which the p-n junction is considered to be flat and infinitely expanded). This is a result of the fact that, at a high reverse voltage across the p-n junction, the field strength at the surface is considerably reduced by the complete depletion of the semiconductor layer.

A disadvantage of the known device is that the overall doping of the semiconductor layer, that is the product of the doping concentration N and the thickness d of the layer must have a value which for silicon is approximately $10^{12}$ atoms/cm². For a given thickness d of the layer the doping concentration N thus is limited by a maximum. This results in the current-conveying capacity of the semiconductor layer is too small for some applications.

Also as a result of this comparatively low doping the disadvantage may occur in certain circumstances that even at a comparatively low reverse voltage across the p-n junction the depletion zone extends from the substrate region into the semiconductor layer up to an active semiconductor zone of the first conductivity type present in said layer, for example, the base zone of a bipolar transistor. This punch-through effect is of particular importance in emitter follower or source follower circuits in which the potential of the semiconductor layer with all the zones present therein is high compared with that of the substrate region.

For these reasons at the same layer thickness it would be preferred to operate with a more highly doped layer in which the said problems do not occur to a much smaller extent. Such a more highly doped layer, however, will not yet be depleted throughout its thickness at the breakdown voltage of the p-n junction, so that the endeavoured increase of the breakdown voltage according to the RESURF principle would not be reached.

It is the object of the invention to provide a semiconductor device having a reduced surface field strength in which a semiconductor layer having a higher doping concentration than in the known device can be used, which layer nevertheless is depleted already over its entire thickness at such voltages that breakdown does not yet occur.

According to the invention, a semiconductor device of the kind described in the opening paragraph is characterized in that the doping concentration of the semiconductor layer is so high that at the breakdown voltage the first depletion zone, belonging to the p-n junction, extends over only a part of the thickness of the semiconductor layer and that a metallically conductive field electrode is present which is separated from the semiconductor layer by a barrier layer and is connected to a potential which at least at a high voltage across the semiconductor circuit element has, with respect to the potential of the semiconductor layer, the same sign as the potential of the substrate region, as a result of which a second depletion zone extends below the field electrode from the surface into the semiconductor layer.

In the semiconductor device according to the invention the semiconductor layer may be depleted both from the side of the substrate region and from the side of the surface. Of the two depletion zones, the depletion zone belonging to the said p-n junction extends in the direction of the surface. The other depletion zone, formed below the field electrode, extends from the surface. As a result of this two-sided depletion the semiconductor layer may have a higher doping concentration than in the known device in which the depletion zone extends only from the substrate region. The field electrode may be connected to an external potential. Preferably, however, the field electrode is connected to a point of the semiconductor body.

The desired two-sided depletion can in many cases be realized efficaciously by giving the field electrode a potential which is substantially equal to that of the substrate region and follows the potential of said substrate region during operation. According to a preferred embodiment, the field electrode is connected to the substrate region.

In other cases, however, this is undesired, for example, in emitter follower circuits, in which the semiconductor layer with all zones present therein is at a high voltage as compared with the substrate region. The field electrode may then be d.c. connected to another point which, at high voltages across the semiconductor circuit element has a potential of the same sign as that of the substrate region with respect to the semiconductor layer.

The invention may be used in semiconductor layers having an inhomogeneous doping concentration. According to a preferred embodiment, however, the semiconductor layer has a substantially homogeneous doping concentration. Such a homogeneously doped layer can be realized in a simple manner by epitaxial growth and, due to the invention, may nevertheless have a higher doping concentration than in RESURF devices without the said field electrode.

The invention will now be described in greater detail with reference to a few embodiments and the drawing, in which

Figure 1 is a diagrammatic cross-sectional view of a semiconductor device in accordance with the invention,

Figure 2 is a diagrammatic cross-sectional view of a modified embodiment of the semiconductor device shown in Figure 1,

Figure 3 is a cross-sectional view of another semiconductor device in accordance with the invention, and

Figure 4 is a diagrammatic cross-sectional view of a modified embodiment of the semiconductor device shown in Figure 3.

The figures are diagrammatic and are not drawn to scale. In particular the dimensions in the direction of thickness are considerably exaggerated. Semiconductor regions of the same conductivity type are hatched in the same direction. Corresponding parts are generally referred to by the same reference numerals.

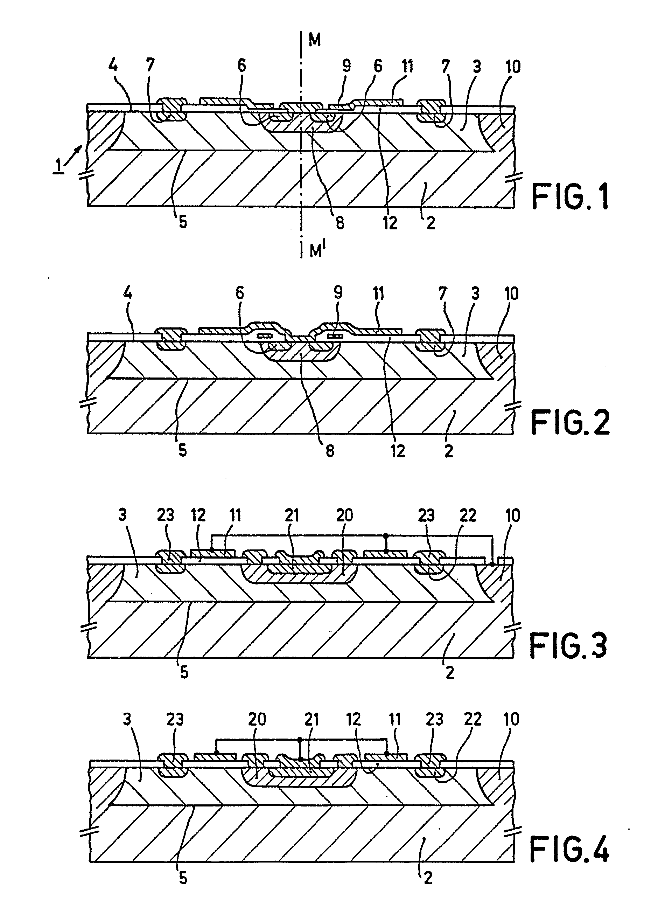

Figure 1 is a diagrammatic cross-sectional view of a semiconductor device in accordance with the invention. The device comprises a semiconductor body 1 which has a substrate region 2 of a first conductivity type. In this example the semiconductor body is of silicon and the substrate region is p-type conductive. A semiconductor layer 3 of the second conductivity type, in this example a substantially homogeneously doped epitaxial n-type silicon layer, is provided on the substrate region 2 so as to adjoin same. The semiconductor layer 3 adjoins a surface 4 of the semiconductor body and with the substrate region 2 forms a p-n junction 5 which in the operating condition is reverse biased.

At least one zone of a semiconductor circuit element is provided within the semiconductor layer 3. In this example the semiconductor circuit element is formed by an n-channel insulated gate field effect transistor of the enhancement type having an n-type source zone 6, an n-type drain zone 7, a p-type channel region 8, and a gate electrode 9. This field effect transistor is provided in an island-shaped part of the layer 3, which part is bounded laterally by a p-type insulation zone 10 which extends from the surface 4 into the substrate region 2. In this example, Figure 1 is rotationally symmetrical about the line MM', although, of course, other non-symmetric configurations may also be used.

The semiconductor device is further designed so that in the operating condition already at a reverse voltage across the p-n junction 5 which is lower than the breakdown voltage, the semiconductor layer 3 is depleted at least locally throughout its thickness and the substrate region 2 is depleted over only a part of its thickness.

In known "RESURF" devices in which the depletion zone of the p-n junction 5 extends up to the surface, for that purpose the product of the doping concentration $N$ and the thickness $d$ of the layer 3 must be approximately $10^{12}$ atoms/cm$^2$. The doping concentration of the layer 3 therefore is comparatively low, which is undesired for various applications.

According to the invention, however, the doping concentration of layer 3 is so high that at the breakdown voltage the depletion zone belonging to the p-n junction 5 does not yet extend throughout the thickness of the layer 3 but only over a part thereof. In this example the product $N \times d$ is more than $1.5 \times 10^{12}$ atoms/cm$^2$, for example $2 \times 10^{12}$ atoms/cm$^2$. This is possible since, also according to the invention, the semiconductor device has a field electrode 11 which is separated from the semiconductor layer 3 by a barrier layer in the form of an electrically insulating layer 12, in this example of silicon oxide, and is connected to a point the potential of which, at least at high voltages across the field effect transistor with respect to the semiconductor layer 3, has the same sign as the potential of the substrate region 2 with respect to the layer 3. For that purpose, in this example the field electrode 11 present between the gate electrode 9 and the drain zone 7 is connected to the gate electrode 9 and forms therewith one single coherent conductive layer.

In the operating condition and at least at high voltages across the field effect transistor, that is to say high source-drain voltages, both the gate electrode 9 (and hence also the field electrode 11) and the substrate region 2 have a negative potential with respect to the semiconductor layer 3. As a result of this, a depletion zone may be formed in the layer 3 both extending from the substrate region 2 and from the field electrode 11, which depletion zones meet each other at a sufficiently high source-drain voltage and at a sufficiently high reverse voltage across the p-n junction 5 and merge to form a single depletion zone occupying the layer 3 in that place over the whole thickness, as a result of which the RESURF condition is satisfied in spite of the higher doping of the layer 3.

As a result of the higher doping concentration of the layer 3 the current-carrying capacity of said layer is higher, hence the "ON" resistance is also lower, and, in source-follower applications, there is a less risk of punchthrough from the substrate region 2 to the channel region 8.

Figure 2 shows a modified embodiment of the device shown in Figure 1. In the Figure 2 embodiment the field electrode 11 is not connected to the gate electrode 9 but to the source zone 6. In this case also the layer 3 is depleted from both sides when the source-drain voltage increases.

Figure 3 is a cross-sectional view of a bipolar RESURF transistor in which the invention is used. The semiconductor layer 3 and the substrate region 2 have dopings and thicknesses which may be equal to those in Figures 1 and 2. The transistor has a p-type conductive base zone 20 and an n-type conductive emitter zone 21. The collector contact 23 is present on the semiconductor layer 3 and is connected thereto via a highly doped n-type contact zone 22. The field electrode 11 is present between the base zone 20 and the collector contact 23 and, in this example, is connected to the substrate region via the highly doped p-type conductive zone 10. When the reverse voltage across the p-n junction 5 increases, the depletion zone extends into the layer 3 both from the substrate region 2 and from the field electrode 11 and both depletion zones merge at a voltage which is amply below the breakdown voltage of the p-n junction 5. As a result of this, RESURF operation is ensured.

For applications in which the transistor is used as an emitter follower, however, this construction is less suitable. The semiconductor layer 3 then is at a high fixed voltage with respect to the substrate region. In that case, for example, the Figure 4 construction in which the field electrode 11 is connected to the emitter zone 21 is to be preferred. Instead of this the field electrode may also be connected to the base zone. Both the emitter zone and the base zone have a negative potential with respect to the layer 3, as has the substrate region 2. As a result of the higher doping of the layer 3 which may be used with two-sided depletion, punch-through from the substrate region to the base zone 20 is avoided while nevertheless the part of the layer 3 present below the field electrode 11 is depleted at high collector-base voltage.

The invention is not restricted to the embodiment described. For example, semiconductor materials other than silicon may be used, while in the examples all conductivity types may (simultaneously!) be replaced by their opposite types. Furthermore, insulating materials other than silicon oxide may be used for the barrier layer 12, while the barrier layer might even be formed by a rectifying metal-semiconductor (Schottky) junction. The field electrode may be, for example, a highly doped layer of polycrystalline silicon covered or not covered with a metal or a metal silicide. Instead of a substantially homogeneously doped epitaxial layer the semiconductor layer 3 may also be an implanted layer and in certain circumstances may advantageously be doped inhomogeneously. For example, the doping concentration may decrease from the p-n junction 5 towards the surface.

**Claims**

1. A semiconductor device of the reduced surface field strength (RESURF) type having a semiconductor body comprising a substrate region of a first conductivity type and an adjoining semiconductor layer of the second, opposite conductivity type which adjoins a surface of the semiconductor body and forms with the substrate region a p-n junction which in the operating condition is reverse biased, within which semiconductor layer at least one zone of a semiconductor circuit element is provided, in which locally the semiconductor layer is depleted throughout its thickness and the substrate region is depleted over only a part of its thickness at a reverse voltage across the p-n junction which is lower than the breakdown voltage, characterized in that the doping concentration of the semiconductor layer is so high that at the breakdown voltage the first depletion zone belonging to the p-n junction extends over only a part of the thickness of the semiconductor layer, and in that a metallically conductive field electrode is present which is separated from the semiconductor layer by a barrier layer and is connected to a potential which, at least at a high voltage across the semiconductor circuit element has, with respect to the potential of the semiconductor layer, the same sign as the potential of the substrate region, as a result of which a second depletion zone extends below the field electrode from the surface into the semiconductor layer.

2. A semiconductor device as claimed in Claim 1, characterized in that the semiconductor layer has a substantially homogeneous doping concentration.

3. A semiconductor device as claimed in Claim 1 or 2, characterized in that the semiconductor circuit element is a lateral insulated gate field effect transistor having a source zone of the second conductivity type provided within a channel region of the first conductivity type which is surrounded by the semiconductor layer of the second conductivity type, the field electrode being present between the gate electrode and the drain zone.

4. A semiconductor device as claimed in Claim 1 or 2, characterized in that the semiconductor circuit element is a bipolar transistor having a base zone of the first conductivity type surrounded by the semiconductor layer of the second conductivity type, an emitter zone of the second conductivity type provided in said base zone and a collector contact provided on the semiconductor layer, the field electrode being present between the base zone and the collector contact.

5. A semiconductor device as claimed in Claim 3, characterized in that the field electrode is connected to the gate electrode.

6. A semiconductor device as claimed in Claim 3, characterized in that the field electrode is connected to the source zone.

7. A semiconductor device as claimed in Claim 4, characterized in that the field electrode is connected to the emitter zone.

8. A semiconductor device as claimed in any of the Claims 1 to 4, characterized in that the field electrode is connected to the substrate region.

## Revendications

1. Dispositif semiconducteur du type à intensité du champ de surface réduite (RESURF) ayant un corps semiconducteur comportant une région de substrat d'un premier type de conductivité et une couche semiconductrice contiguë du second type de conductivité opposé qui est contiguë à une surface du corps semiconducteur et forme avec la région de substrat une jonction pn qui, dans les conditions de fonctionnement, est polarisée en sens inverse, couche semiconductrice dans laquelle est prévue au moins une zone d'un composant semiconducteur, alors que, localement, la couche semiconductrice est appauvrie sur toute son épaisseur et la région de substrat n'est appauvrie que sur une partie de son épaisseur si une tension inférieure à la tension de claquage est présente aux extrémités de la jonction pn, caractérisé en ce que la concentration de dopage de la couche semiconductrice est élevée au point qu'à la tension de claquage, la première zone d'appauvrissement apppartenant à la jonction pn ne s'étende que sur une partie de l'épaisseur de la couche semiconductrice et en ce qu'il est prévu une électrode de champ à conduction métallique qui est séparée de la couche semiconductrice par une couche d'arrêt et est reliée à un potentiel qui, au moins en présence d'une haute tension aux bornes du composant semiconducteur, a le même signe par rapport au potentiel de la couche semiconductrice que le potentiel de la région de substrat, de sorte qu'une second zone d'appauvrissement s'étend audessous de l'électrode de champ, à partir de la surface jusque dans la couche semiconductrice.

2. Dispositif semiconducteur selon la revendication 1, caractérisé en ce que la couche semiconductrice a une concentration de dopage sensiblement homogène.

3. Dispositif semiconducteur selon la revendication 1 ou 2, caractérisé en ce que le composant semiconducteur est un transistor latéral à effet de champ à grille isolée ayant une zone de source du second type de conductivité réalisée dans une région de canal du premier type de conductivité qui est entourée de la couche semiconductrice du second type de conductivité, l'électrode de champ étant située entre l'électrode de grille et la zone de drain.

4. Dispositif semiconducteur selon la revendication 1 ou 2, caractérisé en ce que le composant semiconducteur est un transistor bipolaire ayant une zone de base du premier type de conductivité entourée de la couche semiconductrice du second type de conductivité, une zone d'émetteur du second type de conductivité réalisée dans ladite zone de base et un contact de collecteur réalisé sur la couche semiconductrice, l'électrode de champ étant située entre la zone de base et le contact de collecteur.

5. Dispositif semiconducteur selon la revendication 3, caractérisé en ce que l'électrode de champ est reliée à l'électrode de grille.

6. Dispositif semiconducteur selon la revendication 3, caractérisé en ce que l'électrode de champ est reliée à la zone de source.

7. Dispositif semiconducteur selon la revendication 4, caractérisé en ce que l'électrode de champ est reliée à la zone d'émetteur.

8. Dispositif semiconducteur selon l'une quelconque des revendications 1 à 4, caractérisé en ce que l'électrode de champ est reliée à la région de substrat.

## Patentansprüche

1. Halbleiteranordnung mit reduzierter Oberflächenfeldstärke (RESURF-Type) mit einem Halbleiterkörper mit einem Substratgebiet eines ersten Leitungstyps und einer daran grenzenden Halbleiterschicht vom zweiten entgegengesetzten Leitungstyp, die an eine Oberfläche des Halbleiterkörpers grenzt und mit dem Substratgebiet einen im Betriebszustand in der Sperrrichtung stehenden pn-Übergang bildet, wobei innerhalb der Halbleiterschicht mindestens eine Zone eines Halbleiterschaltungselementes vorgesehen ist wobei, bei einer Sperrspannung an dem pn-Übergang, die niedriger ist als die Durchbruchspannung, wenigstens örtlich die Halbleiterschicht über die ganze Dicke und das Substratgebiet über nur einen Teil der Dicke verarmt ist, dadurch gekennzeichnet, dass die Dotierungskonzentration der Halbleiterschicht so hoch ist dass bei der Durchbruchspannung die dem pn-Übergang zugeordnete, erste Verarmungszone sich über nur einen Teil der Dicke der Halbleiterschicht erstreckt und dass eine metallisch leitende Feldelektrode vorhanden ist, die durch eine Sperrschicht von der Halbleiterschicht getrennt ist und mit einem Potential verbunden ist das, wenigstens bei hoher Spannung an dem Halbleiterschaltungselement, gegenüber der Halbleiterschicht dasselbe Vorzeichen hat wie das des Substratgebietes, wodurch sich unter der Feldelektrode eine zweite Verarmungszone von der Oberfläche in der Halbleiterschicht erstreckt.

2. Halbleiteranordnung nach Anspruch 1, dadurch gekennzeichnet, das die Halbleiterschicht eine nahezu homogene Dotierungskonzentration hat.

3. Halbleiteranordnung nach Anspruch 1 oder 2, dadurch gekennzeichnet, dass das Halbleiterschaltungselement ein lateraler Feldeffekttransistor mit isolierter Gate-Elektrode ist mit einer Source-Zone vom zweiten Leitungstyp, die innerhalb eines Kanalgebietes vom ersten Leitungstyp angebracht ist, das durch die Halbleiterschicht vom zweiten Leitungstyp umgeben ist, wobei die Feldelektrode sich zwischen der Gate-Elektrode und der Drain-Zone befindet.

4. Halbleiteranordnung nach Anspruch 1 oder 2, dadurch gekennzeichnet, dass das Halbleiterschaltungselement ein bipolarer Transistor ist mit einer von der Halbleiterschicht vom zweiten Leitungstyp umgebenen Basiszone vom ersten Leitungstyp, einer darin angebrachten Emitter-Zone vom zweiten Leitungstyp und einem auf der Halbleiterschicht angebrachten Kollektorkontakt, wobei die Feldelectrode sich zwischen der Basiszone und dem Kollektorkontakt befindet.

5. Halbleiteranordnung nach Anspruch 3, dadurch gekennzeichnet, das die Feldelektrode mit der Gate-Elektrode verbunden ist.

6. Halbleiteranordnung nach Anspruch 3, dadurch gekennzeichnet, dass die Feldelektrode mit der Source-Zone verbunden ist.

7. Halbleiteranordnung nach Anspruch 4, dadurch gekennzeichnet, dass die Feldelektrode mit der Emitterzone verbunden ist.

8. Halbleiteranordnung nach einen der Ansprüche 1 bis 4, dadurch gekennzeichnet, dass die Feldelektrode mit dem Substratgebiet verbunden ist.

FIG.1

FIG.2

FIG.3

FIG.4